# EUROPEAN PATENT APPLICATION

(11) **EP 0 685 876 A2**
(43) Date of publication of application: **06.12.1995**
(21) Application number: 95303830.4
(22) Date of filing: 02.06.1995
(51) Int. Cl.: H01L 21/285

(54) **Method of making two types of tin and the layers made by this method**

(30) Priority: 03.06.1994 US 253642
(71) Applicant: VARIAN ASSOCIATES, INC., Palo Alto, California 94304 (US)
(72) Inventor: Biberger, Maximilian, Palo Alto, CA 94306 (US); Tkach, George J., Santa Clara, California 95051 (US); Jackson, Stanley, Sunnyvale, California 94086 (US); Tsai, Wilman, Cupertino, California 95014 (US)
(74) Representative: Cline, Roger Ledlie

(57) **Abstract**

A sputter deposition method with control of the nitridation of a Titanium target into two modes so as to provide reliable and stable control of the characteristics of the TiN layer formed. One such layer is deposited at a rate 3.1 times the other. Also, a novel diffusion barrier layer made from the two types of TiN is provided.

Gas flow rates into the deposition chamber are selected for the appropriate mode and if the pressure in the chamber is found incorrect, then the flow rate of one of the gases is adjusted.

## Description

### Field of the Invention

This invention relates to methods and apparatus for physical vapor deposition and more particularly for the sputter deposition of titanium and titanium nitride as contact and barrier/adhesion layers.

### Background of the Invention

It is known in the art of deposition of material layers for the manufacture of semiconductor microcircuits to employ the bombardment of ions upon the surface of a target in order to dislodge from the target some of the target atoms. The dislodged atoms, in the proper environmental circumstances, will move through space and condense on the surface of a substrate. By repeating the process a layer will form. If the environment of the dislodged atom contains atoms of other materials which can chemically react, the sputtered material can be chemically combined. The formation of titanium, (T) layers and titanium nitride (TiN) layers for several important applications has become increasingly important in recent years.
In most of the most advanced equipment for layer depositions, a semiconductor substrate is automatically passed back and forth between different vacuum isolated modules for different processes without exposing the wafer to the external environment and without human handling or any human intervention. So called "cluster tools" are used in this process where one wafer is being treated at a time in each module. Accordingly, the processing time in each chamber becomes a critical element in the throughput of the apparatus. Also, as the feature size of devices in microcircuits has become smaller, the diameter for the holes in the interlayer dielectric for interconnecting metal between layers (contacts and VIAs) has also become smaller. This has made it more difficult to fill the bottom of the contact/VIA with conducting material as required to obtain the lowest resistance contact/VIA. It is known to use physical collimation of the atoms exiting the target on their way toward to the substrate, i.e., so called controlled divergence sputtering (cds) to improve contact/VIA filling. However use of a collimator results in as much as 90% reduction in the deposition rate for the same power. This has required large increases in the power level and for some processes has caused instabilities resulting in changes in the plasmas and in the stoichiometry of the compounds formed.

### Objects of the Invention

It is an object of the invention to improve the deposition rate of TiN in a sputter deposition without degradation in the stoichiometry of the deposited layer and to provide a stable deposition mode..

It is a further object to provide a process which does not nitride the Ti target surface. It is a still further object of the invention to provide a method to control the nitridation process during sputtering of a Ti target to form selectively one of two types of TiN. It is still another object of the invention to provide a novel diffusion barrier of Ti/TiN*/TiN where TiN* is formed when the target is nitrated and TiN is formed when the target is not nitrated.

### Brief Description of the Drawings

Fig. 1 is an illustration of a cluster tool of the prior art.

Fig. 2 is a schematic cross section of a prior art sputter deposition chamber and flow rate control equipment.

Fig. 3 is a graph illustrating the deposition rate and reflectivity of both modes of TiN deposition.

Fig. 4 is a graph showing the resistivity vs. % Nitrogen for the two modes of TiN.

Fig. 5 is the matrix relating pressure and Argon and Nitrogen flow rates for the two modes of TiN.

Figs. 6 and 6a are alternative flow diagrams for the selection and pressure control for making either mode of TiN according to the embodiment of the invention.

Fig. 7 is a graph showing the Brodsky test sheet resistance of a diffusion barrier made using both types of layers of NM-TiN//NNM-TiN put down on Ti on Si.

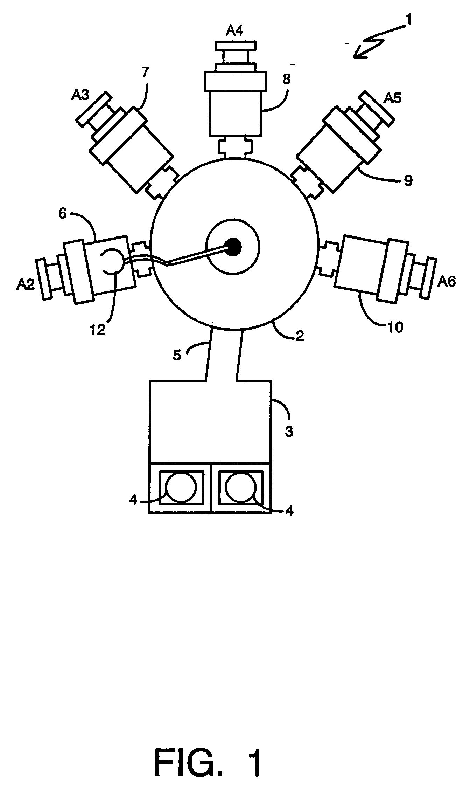

Fig. 1 is a schematic of a cluster tool 1 of the prior art. Silicon wafers are loaded into a carrier tray 4 are automatically unloaded from the carrier trays by a first transfer arm (not shown) and degassed. Next, the wafer is picked up by the transfer arm 11 of the cluster tool main chamber 2 and passed through the vacuum lock 5 into the cluster tool cemtral main chamber 2. The transfer arm 11 under a control of a computer then moves the wafer into the and out of the modules 6, 7, 8, 9 and 10 sequentially as the process demands. Since each module is separated from the main chamber by a load lock 5, the various processors are able to work simultaneously in their own controlled environment. The Varian Model M2000/8 Cluster Tool contains five modules around its periphery and most commonly three or more of the modules are sputter deposition modules which are capable of sustaining a high vacuum environment and introducing various gases and targets for the sputter deposition of a semiconductor substrate.

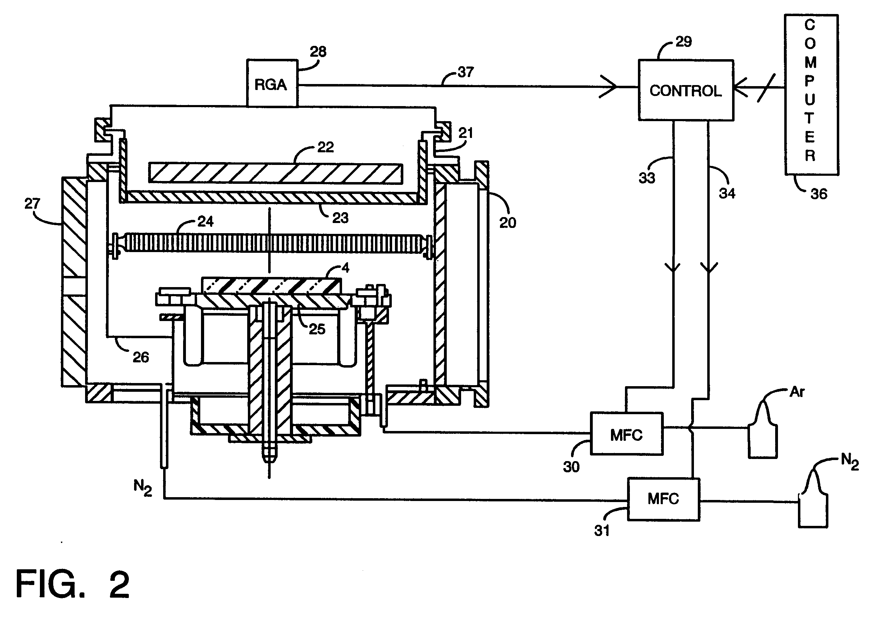

With reference to Fig. 2, the basic elements of a sputter module of the prior art is illustrated. The flange 20 is connected to the vacuum gate valve 5 of Fig. 1 to receive the substrate 4 from the transfer arm 11 which is placed onto the support 25. In some instances support 25 is a cooling or heating device which is maintained at the opposite potential from the target 23. In the prior art, it was customary to clamp the wafer to the support 25 for better grounding and heat transfer. In our preferred embodiment the wafer rests on support 25 by gravity but we do not clamp the wafer to the support for reasons which will be explained subsequently. Mounted above and on the opposite side of the chamber from the wafer is the target 23 which in this instance is made from pure titanium. Mounted between the target 23 and the wafer 4 is a collimator 24 which is made of plastic material having hexagonal shaped openings on the order of 16mm across and a depth of about 24mm. Inside the vacuum chamber formed by the walls 27, a plasma is initiated and sustained in a Argon environment when depositing Ti and in an Argon and Nitrogen environment when depositing TiN. The voltage to sustain the plasma is applied across the target which is isolated from the chamber by appropriate insulators. Outside of the vacuum environment but adjacent, the target is a magnet assembly 22 which is rotated by drive apparatus which is not illustrated. The magnet rotation is required to improve the utilization of the target and to improve the uniformity at the wafer of the deposited layer.
Applicants have discovered that the instability problem observed in the prior art TiN deposition process was due to diminished pumping speed of the cryopumps due to heating up of the cryopump as a result of the increased power levels required when using a collimator during deposition. This discovery lead to an investigation of the reactions in the chamber to try to understand the reason for the pressure sensitivity. Our study has lead to the discovery that there are two distinct modes of operation of the titanium target during operation in the presence of nitrogen. We call these two modes the non-nitrided mode (NNM) and the nitrided mode (NM). In the nitrided mode, as the name suggests, we have found that the nitrogen reacts with the titanium on the target surface and results in the presence of a layer of titanium-nitrogen compound on the surface. This layer very significantly reduces the sputter rate of titanium from the target. We have also determined that the layer of TiN formed on the semiconductor substrate when the target is in the NM is less dense, and has higher sheet resistance characteristic. Accordingly, for some applications NNM layers may be more desired than the NM layer and visa-versa. Our research also lead to the discovery that although the pressure parameter controlled the mode of the TiN, we found that there was a pressure range for each value of the ratio of Argon to Nitrogen flow rates in which either modes could be selectively obtained. Accordingly, our goal has been to define the means and methods in which to control the process to achieve either mode selected.

Although we do not wish to be bound by theory, we believe that because of the presence of the collimator the flux of titanium just above the collimator (below the target) is much greater than the flux of titanium near the wafer. In the NNM, there is a balance of Ti and N₂ flux so that the target surface layer contains both exposed Ti and TiN. But, when the N₂ flux exceeds the balanced ratio, the TiN saturates the surface layer of the target and the sputter rate of Ti decreases because the TiN layer needs to be sputtered off first by the Ar ions.

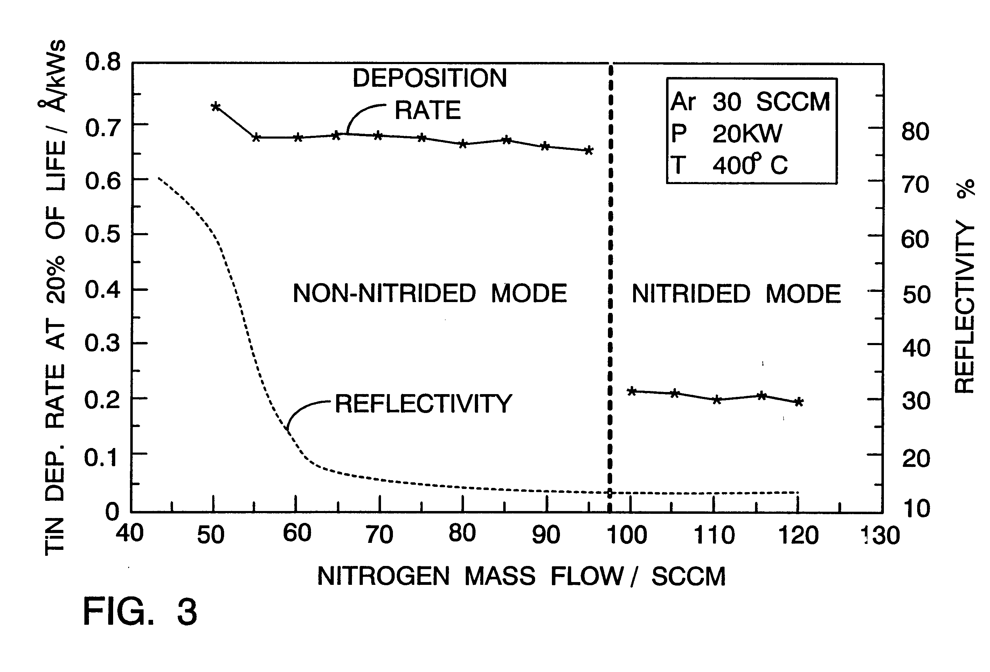

With reference to Fig. 3 graph, for a fixed flow rate of Argon, (30sccm) using a 15 mm collimator, it is seen that the deposition rate in the NNM region is more than 3 times faster than for the NM region. The second curve describes reflectivity of the deposited layer. It is seen that the average reflectivity for a TiN layer as a function of the mass flow percentage of N₂ during layer formation increases rapidly at approximately 60sccm of N₂ flow.

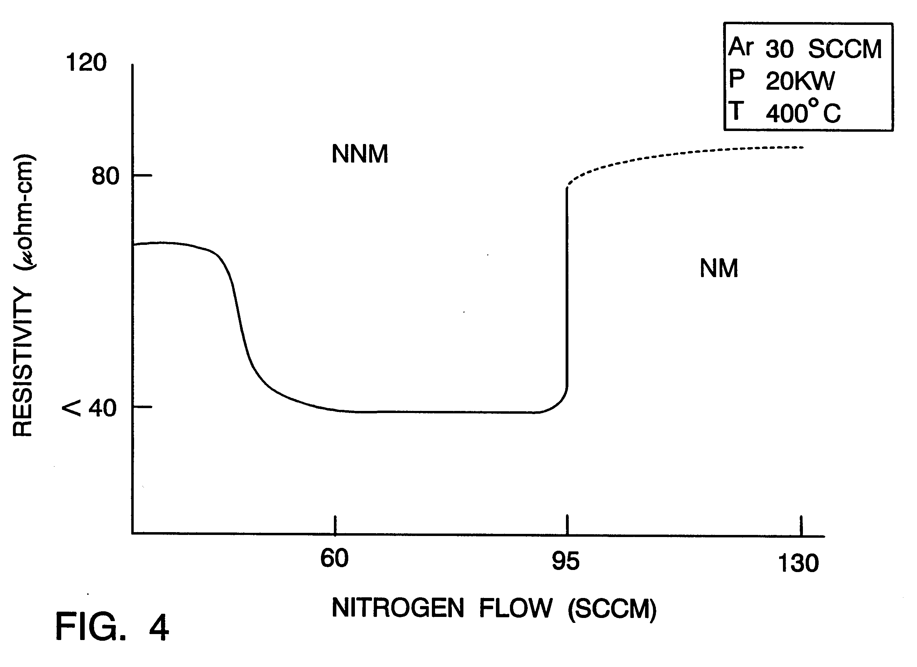

With reference to Fig 4, a graph is seen that shows that the sheet resistivity varies across both the NNM and NM regions. It is seen that in the nitrided mode that the bulk resistivity is approximately 2-3 times higher than in the non-nitrided mode. A very sharp transition is observed between the modes, i.e., 95sccm of N₂ flow.

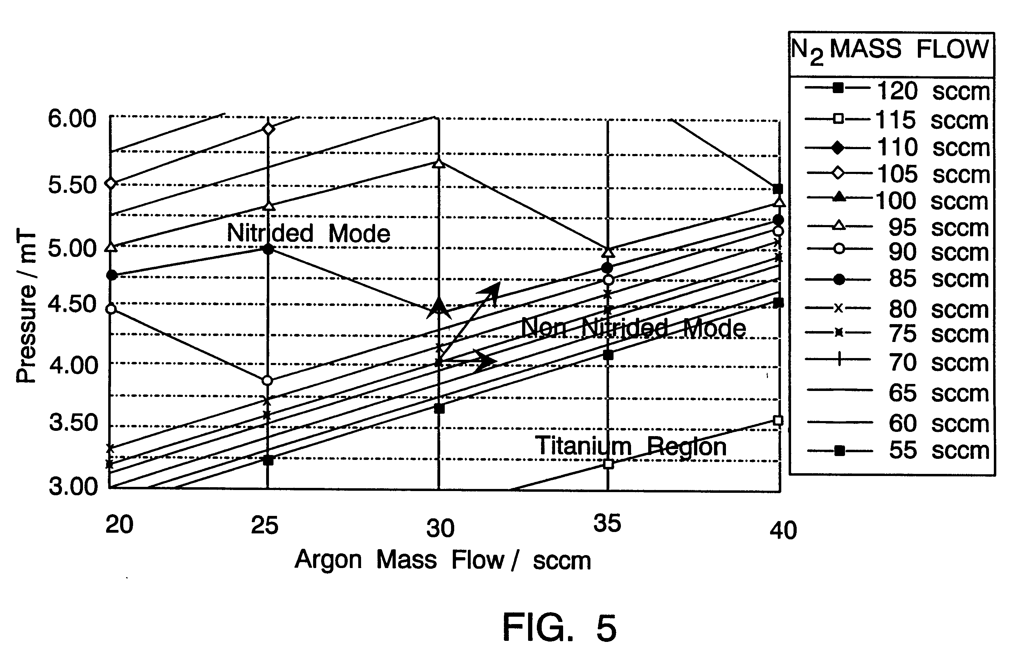

Fig. 5 is a graph showing the matrix of the flow rate of Argon for various chamber pressures for different nitrogen flow rates. It can be seen from this graph that there exists a pressure at which either the NM or NNM is achievable for each ratio of Ar/N flow rate. The horizontal arrow in this graph indicates an increase in the partial pressure of Ar and the vertical arrow indicates an increase in the particle pressure of N. The resultant arrow indicates the sum of the partial pressures and illustrates how an increase in the partial pressure of nitrogen can cause a process to shift out of the NNM mode into the NM and similarly, that a decrease in the Ar flow rate at fixed N₂ flow can also cause a shift from NNM to the NM.

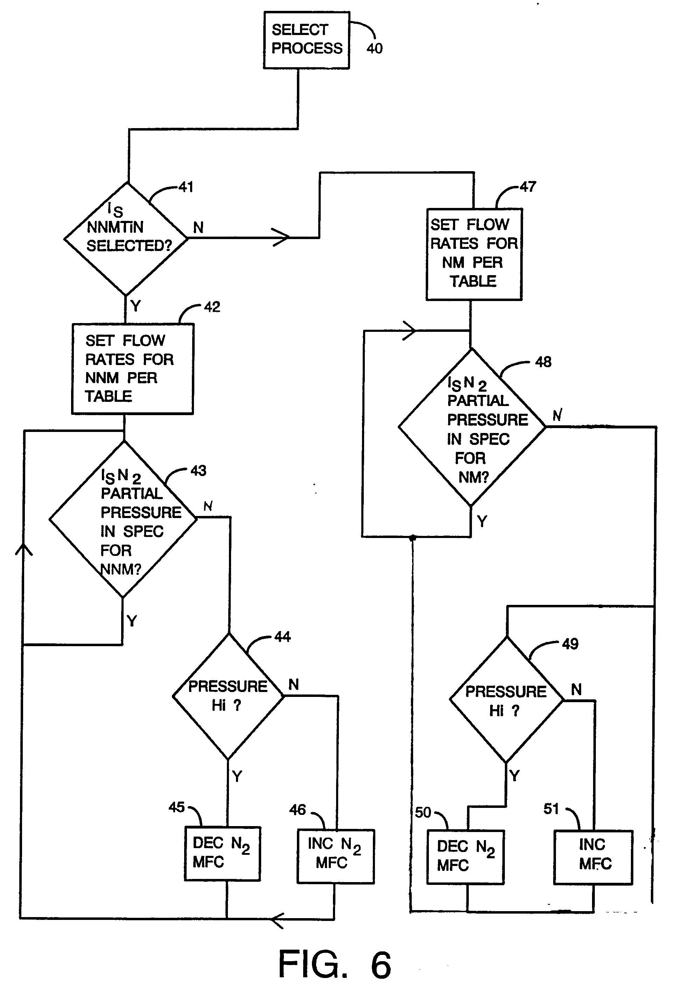

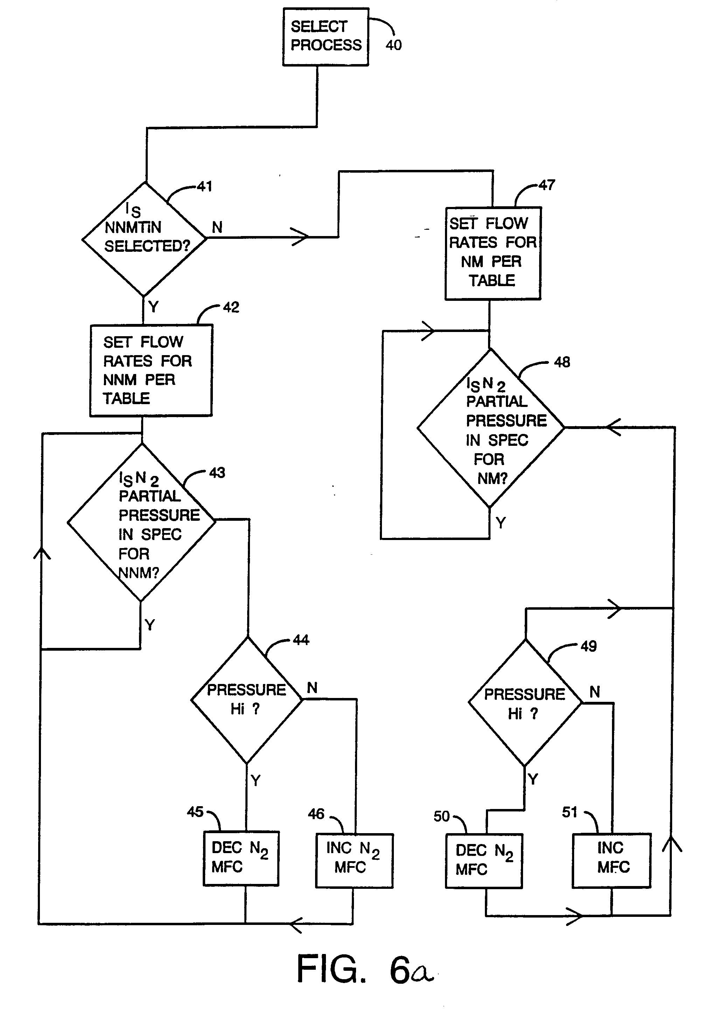

According to Fig. 6, in order to maintain stability and produce only the type of TiN layer desired for a particular process, a relatively simple control scheme will accomplish this task. Specifically, for each process selected which involves the production of a TiN layer, the main controller shall preferably have a table for the particular process which will indicate which of the two types of layer is to be made. If the NNM type, 41, is to be made, the flow rates will be established as determined in the Table 42, the plasma initiated, and then a pressure measurement will be made. Preferably, a residual gas analyzer 28 will be used to measure the partial pressure of one of the two gases. The pressure measurement will be compared to a reference level and a correction flow rate of N₂ 45, or Argon initiated. As shown in the flow diagram, the pressure is then continuously controlled about the reference level until the process is completed. Alternatively, and not illustrated, one of the gases could be maintained at a constant flow rate and the total chamber pressure could be controlled by the flow rate of the other gas. Still another control technique, could be to monitor and control the partial pressure of both gases, with reference to an algorithm which is computed on the basis of the pressure measurements to provide signals to control the mass flow controllers (MFC).

There can be a distinct advantage in using the NNM-TiN mode as a last step on a wafer in certain of the deposition modules since the Ti target has no TiN on its surface at the end of the NNM-Ti process. This makes it possible to immediately apply a pure Ti layer on the top of the next substrate to be introduced into the chamber. This means that throughput would be increased since the chamber can accommodate sequential deposition of different layers without any intermediate cleaning.
There are multiple applications to which layers made by these inventive processes are useful. One such newly discovered use is as a diffusion barrier. Diffusion barriers are known in theart as a means to avoid some of the effects which occur as a result of processes which cause materials to move around i.e., diffuse, particularly if they are soluble in the materials in which they come into contact. In semiconductor manufacturing due to high temperature processes, this is a particular problem in connection with the regions in which aluminum contacts silicon. It has been known for a long time that when silicon diffuses into the Al, it can cause many types of problems. Various materials have been used in the past as a diffusion barrier including Ti, W, TiW, as well as multiple layers of materials such as Ti/TiW/Ti and TiW/TiN. Each of these barriers has been successful in some instances depending on the temperature of subsequent processes and depending on the thickness and stresses in the various layers. In general, thicker layers are more time consuming to deposit and are usually more problematic because of stress problems. Although thick TiN layers on Ti on the order of 2000A, are known in the prior art to be successful, they are undesirable because of their thickness, i.e., time to deposit and stress induced problems such as peeling.

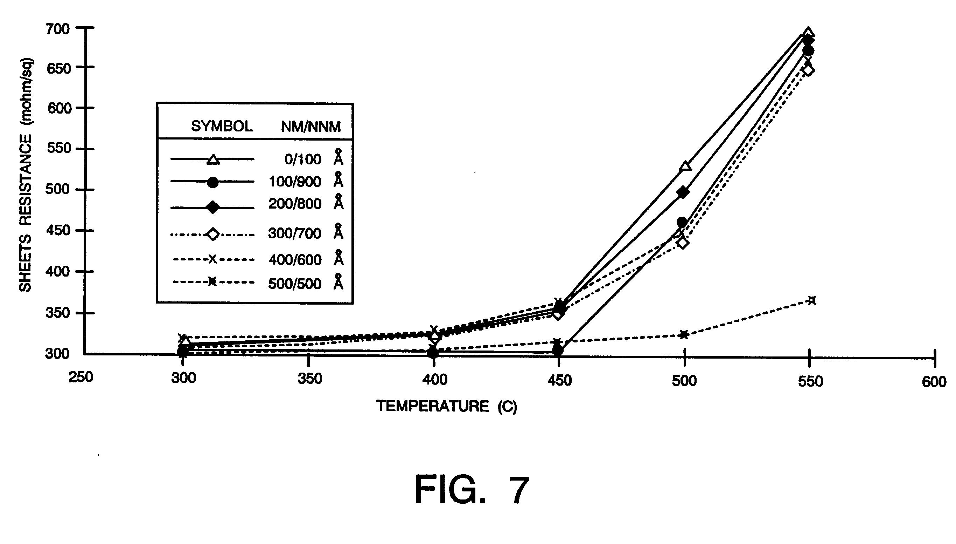

We have discovered that when the nitrided mode TiN (NM-TiN) is layered on the titanium on silicon and the non-nitrated mode TiN (NNM-TiN) is layered on the NM-TiN type layer that a very successful and reasonably fast growth rate diffusion barrier is formed. With reference to Fig. 7, the results of the Brodsky test for the novel diffusion barrier is plotted for various thicknesses of the TiN-N/TiN-NNM layers under an aluminum-copper. As can be seen in this graph, when both the layer of NM-TiN and NNM-TiN are 500A that the resistivity is less than about 360 mohms/sq. up to 550° C anneal temperature.

Tests have been performed using a Spiking test and the results were as equally as impressive with a blanket p-Si patterned structure with 0.6 micron contact holes .
The wafers for the Brodsky test were prepared as follows:
1. p-Si wafers degassed at 550° C for 10 min.
2. 200A cds Ti @ 12KW at 400° C.
3. x A cds NM-TiN @ 20KW @ 400° C.
4. y A cds NNM-TiN @ 20KW @ 400° C.
5. cool with BSA@ 25° C for 2 min.
6. Al-0.5%Cu metallization.
7. 400-550° C furnace anneal for 1 hr. in 50° C steps.

Where cds means "controlled divergence sputtering" with a collimator. The apparatus for doing cds is more fully described in the related patent application entitled, "Collimated Deposition," S/N 134351 filed October 8, 1993, incorporated herein by reference.
The success of this novel diffusion barrier was unexpected because it was unexpected that the slight difference between the stoichiometry of the two different TiN layers would produce any noticeable difference in their grain boundaries. In addition, the distinction between the layers can be seen on an electron microscope view of the cross section of the diffusion barrier.

## Claims

1. A method for depositing Titanium Nitride (TiN) on a semiconductor wafer in a sputter deposition chamber having a Titanium target comprising:
(a) selecting which TiN mode layer is to be deposited, said selection being between the non-nitride mode (NNM) and the nitride mode (NM);
(b) selecting the flow rates of Argon gas and Nitrogen gas consistent with the requirements to produce the said selected mode of TiN and starting deposition of a first said selected mode layer on said semiconductor wafer;
(c) measuring the pressure in said sputter deposition chamber during said deposition;
(d) determining whether the measured pressure in said chamber is correct for said mode selected and if not, correcting the pressure in said chamber by adjusting the flow rate of one of said gases.

2. The method of claim 1 wherein said step of measuring the pressure in sputter deposition chamber comprises measuring the partial pressure of one of said gases.

3. The method of claim 1 wherein the step of measuring the pressure in said sputter deposition chamber comprises measuring the total pressure in said chamber.

4. The method of claim 1 wherein said step of measuring the pressure in said chamber comprises measuring the partial pressure of both the Ar and N2 gas in said chamber,

5. The method of claim 1 wherein the step of determining whether the measured pressure is correct includes comparing said measurement to a value in a table stored in a computer.
